# EUROPÄISCHE PATENTSCHRIFT

(11) **EP 0 390 726 B1**
(45) Veröffentlichungstag und Bekanntmachung des Hinweises auf die Patenterteilung: **01.09.1993**
(21) Anmeldenummer: 90810022.5
(22) Anmeldetag: 09.01.1990
(51) Int. Cl.: C23C 14/30

(54) **Tiegelabdeckung für Beschichtungsanlagen mit einer Elektronenstrahlquelle**
Crucible cover for coating systems with an electron beam source
Couvercle de creuset pour appareillages de revêtement à source de faisceau électronique

(30) Priorität: 09.02.1989 CH 445/89
(43) Veröffentlichungstag der Anmeldung: 03.10.1990
(73) Patentinhaber: BALZERS AKTIENGESELLSCHAFT, 9496 Balzers (LI)
(72) Erfinder: Stössl, Wilfried, A-6840 Götzis (AT); Beusch, Christian, FL-Triesenberg (LI); Bösch, Martin, Dr., CH-9478 Azmoos (CH); Niggli, Peter, FL-9490 Vaduz (LI)
(74) Vertreter: Bruderer, Werner

(56) Entgegenhaltungen:
- GB-A- 2 170 823

## Beschreibung

Die Erfindung betrifft eine Tiegelabdeckung für Beschichtungsanlagen mit einer Elektronenstrahlquelle als Energiequelle, einem schwenk- oder drehbaren Tiegel mit mehreren Materialtaschen und einer Abdeckung für die nicht mittels der Energiequelle beheizten Materialtaschen.

Bei den bekannten Vakuumbeschichtungsverfahren, wie beispielsweise mittels der thermischen Verdampfung durch Elektronenstrahlkanonen, werden die zu beschichtenden Objekte in eine Vakuumkammer eingebracht. In dieser Vakuumkammer befindet sich bei Anlagen zur Aufbringung von unterschiedlichen Schichten im gleichen Verfahren ein Tiegel mit mehreren Materialtaschen, welche die verschiedenen Materialien enthalten. Eine solche Einrichtung ist aus der schweizerischen Patentschrift Nr. 663 037 bekannt, wobei der Tiegel in der Einrichtung, bzw. der Quelle so eingebaut ist, dass Dreh- oder Schwenkbewegungen des Tiegels ermöglicht und dadurch eine Positionierung der Materialtasche mit dem Beschichtungsmaterial in die gewünschte Aufdampfposition ermöglicht wird. In dieser Einrichtung befinden sich auch Kühleinrichtungen und die Energie-, bzw. Elektronenstrahlquelle für das Schmelzen und Verdampfen des Beschichtungsmateriales in der gewünschten Materialtasche. Werden auf einer derartigen Anlage auf die zu bedampfenden Objekte nacheinander mehrere Schichten von unterschiedlichen Materialien aufgebracht, zum Beispiel bei der Herstellung von Elektronik-Chips, so darf die Vakuumkammer vor Abschluss des Bearbeitungsvorganges nicht geöffnet werden. Andernfalls entstehen in den Interfaceregionen zwischen den Einzelschichten nicht kontrollierte Reaktionen, und die Vakuumbedingungen entsprechen nicht mehr den Vorgaben. Dies führt zu Ausschussware an sehr teuren Substraten. Bei diesen Arbeitsvorgängen werden Tiegel verwendet, welche zwei, drei, vier oder mehr Materialtaschen beinhalten, wobei jede dieser Taschen mit einem anderen Beschichtungsmaterial bestückt sein kann. Diejenigen Materialtaschen, deren Materialinhalt nicht verdampft wird, müssen während des Verfahrensablaufes abgedeckt werden, damit ihr Materialinhalt nicht durch das in Verarbeitung stehende Beschichtungsmaterial verunreinigt wird. Aus der CH 663 037-A5 ist es bekannt, diejenigen Teile des Tiegels, welche während eines bestimmten Verfahrensschrittes nicht benötigt werden, mittels einer Abdeckung vor Verunreinigung zu schützen. Diese bekannten Abdeckungen sind fest angeordnet und möglichst nahe auf die Oberfläche des Tiegels, bzw. der Materialtaschen abgesenkt, um Verunreinigungen zu verhindern. Bei der Verwendung von stark streuenden Beschichtungsmaterialien, wie z.B. Gold, oder bei grossen Tiegelvolumen ist die Gefahr des Uebersprechens vergrössert, wodurch weitere Verunreinigungen auftreten, welche bei besonders hohen Anforderungen an die Beschichtungsqualität unerwünscht sind. Stark streuende Materialien können auch den Bewegungsablauf des Tiegels stören. Diese Störungen sind darauf zurückzuführen, dass sich in den Spaltbereichen zwischen Abdeckung und Tiegel sowie Materialtaschen Material, welches im momentanen Beschichtungsprozess verdampft wird, ablagert und nach einer gewissen Zeit die Bewegungsvorgänge des Tiegels nicht mehr durchführbar sind. Dies hat zur Folge, dass die Vakuumkammer geflutet werden muss, um den Tiegel und die Abdeckung reinigen zu können, wodurch einerseits Betriebsunterbrüche entstehen, und anderseits die Qualität der sich in der Vakuumkammer in Bearbeitung befindlichen Substrate nicht mehr gewährleistet werden kann. Diese müssen als Ausschuss behandelt werden, und es entstehen sehr hohe Verlustkosten, da es sich in den meisten Fällen um sehr teure Objekte handelt.

Es ist Aufgabe der vorliegenden Erfindung, eine Tiegelabdeckung zu schaffen, welche eine sehr hohe Betriebssicherheit aufweist, eine vollständige Abschirmung der in einem bestimmten Verfahrensschritt nicht benötigten Materialtaschen vor Verunreinigungen gewährleistet, welche einfach herstellbar ist und im Bereiche der Vakuumkammer eine hohe Funktionssicherheit aufweist. Im weiteren ist es Aufgabe der Erfindung, mittels dieser Vorrichtung Betriebsunterbrüche zu vermeiden, und dadurch die Ausschusskosten zu reduzieren.

Diese Aufgabe wird durch die im kennzeichnenden Teil des Patentanspruches 1 angegebenen Merkmale gelöst. Verschiedene Ausführungsformen ergeben sich nach den Merkmalen der abhängigen Patentansprüche.

Bei der erfindungsgemässen Lösung ermöglicht die zwischen dem Tiegel und der Abdeckung angebrachte Hubeinrichtung eine spaltfreie, optisch dichte Abdichtung zwischen der Oberfläche des Tiegels und den Dichtelementen an der Abdeckung. Mittels der Hubeinrichtung wird die Abdeckung auf die Oberfläche des Tiegels abgesenkt, sobald sich der Tiegel in der gewünschten Position befindet. Zur Positionierung des Tiegels sind in bekannter Weise Schwenk- oder Dreheinrichtungen einsetzbar. Allfällige Ablagerungen von Beschichtungsmaterial im Uebergangsbereich zwischen Abdeckung und Tiegeloberfläche können den Bewegungsablauf des Tiegels nicht stören, da vor jeder Veränderung der Tiegelposition der Zwischenraum zwischen Abdeckung und Tiegeloberfläche mittels der Hubeinrichtung vergrössert wird, und dadurch allfällige Materialdepots den Bewegungsablauf des Tiegels nicht behindern können. Die Veränderung des Abstandes zwischen Abdeckung und Tiegel ist entweder durch Bewegen der Abdeckung oder des Tiegels erreichbar. Besonders zweckmässig lässt sich die Erfindung durch Zwangsbetätigung anwenden, wenn am Mantel des Tiegels eine Führungsbahn in der Form einer Kulissennute angeordnet wird und in diese Führungsbahn Führungselemente eingreifen, welche mit der Abdeckung verbunden sind. Die Führungsbahn weist eine geometrische Form auf, welche auf die Anzahl der Taschen und die Grösse der gewünschten Bewegungsschritte abgestimmt ist und gewährleistet, dass der Abstand zwischen Abdeckung und Tiegeloberfläche immer so gross ist, dass Bewegungsvorgänge des Tiegels nicht behindert werden. Dies wird dadurch gewährleistet, dass die Abdeckung gegen eine Federbelastung von der Oberfläche abgehoben wird, sobald eine Dreh- oder Schwenkbewegung des Tiegels, bzw. der am Mantel des Tiegels angeordneten Führungsbahn erfolgt. Dazu sind in dieser Führungsbahn Vertiefungen oder Erhöhungen angeordnet, welche über die Führungselemente die Positionsveränderung der Abdeckung bewirken. Dadurch, dass die Bewegungsvorgänge bei Positionsveränderungen des Tiegels zur Betätigung der Hubvorrichtung eingesetzt werden, ergibt sich eine besonders einfache und funktionssichere Lösung. Die erfindungsgemässe Lösung lässt sich auch sehr leicht in bereits bestehende Anlagen einbauen und erhöht die Qualität der auf die Substrate aufgebrachten Beschichtungen wesentlich. Es tritt keine kreuzweise Verunreinigung der Materialien in den einzelnen Taschen auf, und damit erreicht man reinere Schichten. Die ganze Steuerung, der Antriebsmechanismus des Tiegels und auch die Beheizung der Materialtaschen bedarf keiner Aenderungen um die erfindungsgemässe Vorrichtung anwenden zu können. Je nach gewählter Konstruktion ist die Abdeckung beweglich und der Tiegel in Achsrichtung feststehend, oder der Tiegel ist in Achsrichtung verschiebbar und die Abdeckung feststehend. Beide Ausführungsvarianten entsprechen der erfindungsgemässen Lösung und führen zu den gewünschten besseren Betriebsresultaten.

Nachfolgend wird die Erfindung anhand von in den Zeichnungen dargestellten vorteilhaften Ausführungsbeispielen näher erläutert.
- Fig. 1: zeigt einen Teilschnitt durch eine erfindungsgemässe Abdeckung und einen Tiegel und die entsprechenden Zusatzaggregate.
- Fig. 2: zeigt eine vereinfachte Darstellung der Seitenansicht eines Tiegels mit zwei Materialtaschen und abgehobener Abdeckung.
- Fig. 3: zeigt die Aufsicht auf den Tiegel in der in Figur 1 dargestellten Position mit zwei Materialtaschen.
- Fig. 4: zeigt die gleiche Einrichtung wie Figur 1, jedoch mit einer Hubeinrichtung zur Parallelverschiebung der Abdeckung.

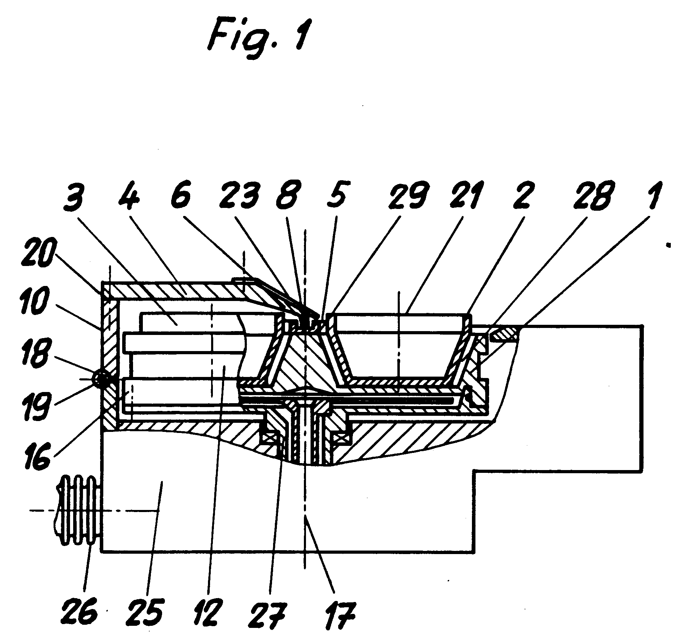

Figur 1 zeigt einen Quellenmodul aus einer Beschichtungsanlage, welcher aus einem Tiegel 1, einer Abdeckung 4 und einem Trägerblock 25 besteht. Der Trägerblock 25 enthält nicht dargestellte Antriebseinrichtungen und eine Kühleinrichtung für den Tiegel 1 sowie die Elektronenstrahleinheit, welche der Beheizung des zu verdampfenden Materiales in Materialtaschen 2, 3 dient. Eine Verbindungsleitung 26 enthält Steuer- und Energiezuleitungen und verbindet den Trägerblock 25 mit den übrigen Modulen der Beschichtungsanlage. Beim Betrieb der Anlage ist die dargestellte Baueinheit in einer Vakuumkammer angeordnet, und alle Lagerungen und Verbindungsleitungen sind dementsprechend ausgebildet. Der Tiegel 1 ist auf einer Welle 27 gelagert und um eine Zentralachse 17 drehbar. Die Welle 27 wird von dem im Trägerblock 25 angeordneten Antrieb angetrieben. Im Tiegel 1, welcher die Form einer runden Scheibe hat, sind zwei Vertiefungen 28 angebracht, welche gegeneinander um 180° versetzt sind. In jeder dieser Vertiefungen 28 befindet sich eine mit Material beschickte Materialtasche 2, 3, auch "Liner" genannt, oder das Material wird direkt in die Vertiefungen 28 eingebracht. Dieses Material wird erwärmt und verdampft und als Beschichtung auf die in der Vakuumkammer angeordneten Substrate aufgebracht. Derartige Materialien sind beispielsweise Gold, Chrom, Aluminium sowie Nickel oder Kupfer. Der in Figur 1 dargestellte Tiegel 1 enthält zwei Liner 2, 3 mit je unterschiedlichen Materialien. Dies ermöglicht die Aufbringung von zwei unterschiedlichen Schichten auf die Substrate im gleichen Arbeitsvorgang ohne dass die Vakuumkammer geöffnet werden muss. Nur eine der beiden Materialtaschen 2, 3 wird von dem in der Elektronenstrahleinheit erzeugten Elektronenstrahl beaufschlagt und somit beheizt. Im dargestellten Beispiel ist dies die Materialtasche 2. Die Materialtasche 3 ist vollständig von der Abdeckung 4 haubenartig abgedeckt. Diese Abdeckung 4 schützt den Inhalt der Materialtasche 3 vor Verunreinigungen durch Materialpartikel, welche aus der Materialtasche 2 austreten und nicht auf die Substrate auftreffen, sondern im Bereiche des Quellenmoduls auftreffen.

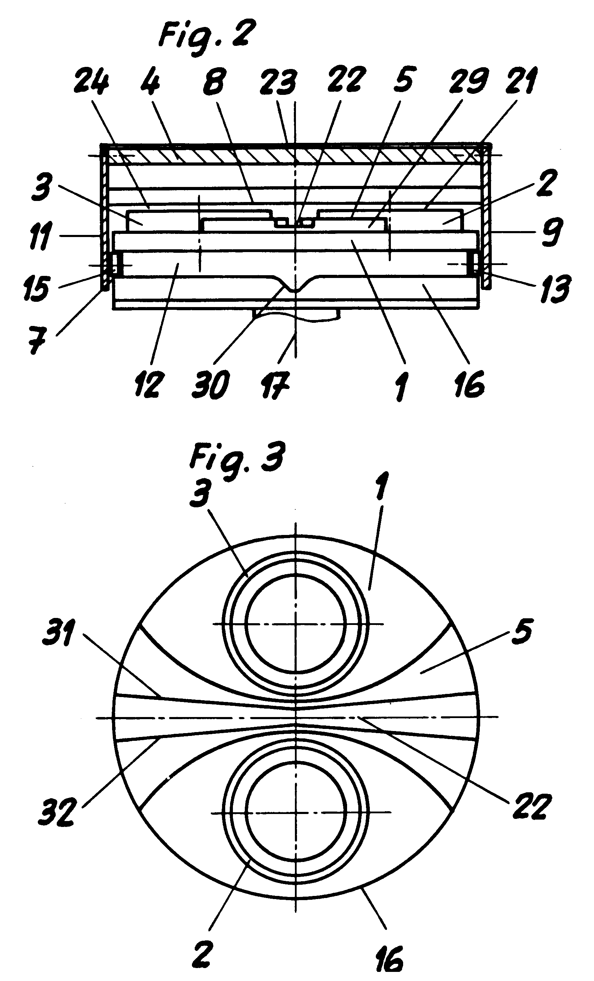

Zur Gewährleistung einer einwandfreien Abdichtung ist am Tiegel 1 ein Zwischenstück 29 angeordnet, welches durch die Zentralachse 17 verläuft und sich zwischen den beiden Materialtaschen 2, 3 erstreckt. Dabei ist die Oberfläche 5 dieses Zwischenstückes 29, bzw. des Tiegels 1 mindestens einen Millimeter tiefer angeordnet als die Oberkante 21 der Materialtaschen 2 oder 3. Die Abdeckung 4 bedeckt eine Hälfte des scheibenförmigen Tiegels 1 und weist entlang ihres Randes 6 Abdichtungen 8 auf und ist in dem von der beheizten Materialtasche 2 entfernten Bereich 20 an der hinteren Schürze 10 in einer Lagerung 19 um eine Achse 18 schwenkbar gelagert. Die Achse 18 erstreckt sich etwa rechtwinklig zur Zentralachse 17 des Tiegels 1. Zusätzlich sind an der Abdeckung 4 nicht dargestellte Federn angeordnet, welche dafür sorgen, dass die Abdichtung 8 mit einem gewünschten Anpressdruck auf der Oberfläche 5 des Tiegels 1 aufliegt. Der Anpressdruck gewährleistet die notwendige Kühlleistung. Zwischen Tiegel 1 und Abdeckung 4 ist eine in Figur 2 dargestellte Hubeinrichtung 7 angeordnet, welche aus einer am Mantel 16 des Tiegels 1 angeordneten Führungsbahn 12 und zwangsweise in dieser Führungsbahn 12 geführten Führungselementen besteht. Diese Führungselemente sind mit der Abdeckung 4 verbunden und erzeugen abhängig vom Verlauf der Führungsbahn 12 eine zwangsweise Schwenkbewegung der Abdeckung 4 um die Achse 18.

Die Funktionsweise der Hubeinrichtung 7 ist in Figur 2 besser erkennbar, wobei in Figur 2 der Tiegel 1 gegenüber Figur 1 um 90° verdreht dargestellt ist. Die Führungsbahn 12 verläuft um den ganzen Mantel 16 des Tiegels 1 und weist zwei Vertiefungen 30 auf. Die Anzahl der angeordneten Vertiefungen ist abhängig von der Anzahl der im Tiegel 1 vorhandenen Materialtaschen, d.h. im dargestellten Beispiel zwei. Die Vertiefungen 30 sind ebenfalls um 180° versetzt. Bei der Darstellung gemäss Figur 2 ist die Abdeckung 4 von der Oberfläche 5 des Tiegels 1 abgehoben, wodurch die Materialtaschen 2, 3 unbehindert von irgendwelchen Dicht- oder Bauelementen in eine neue Position gebracht werden können. Die Abdeckung 4 weist seitliche Schürzen 9 und 11 auf, an welchen die Führungselemente 13 und 15 gelagert sind. Bei diesen Führungselementen 13, 15 handelt es sich um Kugellager, deren äussere Laufflächen von der Führungsbahn 12 geführt sind und trotzdem ein ungehindertes Verdrehen des Tiegels 1 um die Zentralachse 17 gewährleisten. Zwischen den Schürzen 9 und 11 sowie dem Tiegel 1, bzw. dem zum Tiegel gehörenden Zwischenstück 29 sind zusätzliche nicht dargestellte Dichtungsteile angeordnet. Wird der Tiegel 1 aus der in Figur 2 dargestellten Position in irgend einer Richtung um die Zentralachse 17 verdreht, gelangen die Führungselemente 13, 15 nach 90° Drehbewegung in den Bereich der Vertiefungen 30. Da die Abdeckung 4 federbelastet ist, wird diese nach unten gezogen, und die Führungselemente 13, 15 laufen in die Vertiefungen 30 hinein, wodurch der Rand 6 mit der Abdichtung 8 auf die Oberfläche 5 des Zwischenstückes 29 abgesenkt wird. Die Dichtung 8 greift dabei in eine Nute 22 ein und bewirkt infolge der auf die Abdeckung 4 wirkenden Schliesskräfte eine einwandfreie Abdichtung zwischen Tiegeloberfläche 5 und Abdichtung 8. Soll eine der Materialtaschen 2, 3 in eine andere Arbeitsposition gebracht werden, so wird der Tiegel 1 wieder um die Zentralachse 17 verdreht, was bewirkt, dass die Führungselemente 13, 15 angehoben werden, weil sie zwangsweise aus der Vertiefung 30 herausgeführt werden. Dadurch wird auch die Abdeckung 4 soweit angehoben, bis zwischen der Oberkante 21 der Materialtaschen 2, 3 und der Abdichtung 8 ein genügend grosser freier Durchlass 24 entsteht. Um einen einwandfreien Bewegungsablauf zu gewährleisten ist die Nute 22, wie in Figur 3 dargestellt, speziell ausgebildet. Die Nute 22 ist vom Zentrum des Tiegels 1 ausgehend erweitert, so dass ihre Breite nach aussen zunimmt. Diese Ausführungsform erlaubt ein verzögertes Herauslaufen der Führungselemente 13, 15 aus der Vertiefung 30 und ein damit verbundenes verzögertes Herausfahren der Abdichtung 8 aus der Nute 22, ohne dass die Abdichtung an den Randbereichen 31, 32 der Nute 22 ansteht.

Zur Verbesserung der Funktion und zur Erhöhung der Standzeit dieser Einrichtung sind wie in Figur 1 und 2 dargestellt am Rand 6 der Abdeckung 4 Schutzelemente 23 angeordnet. Diese Schutzelemente 23 sind leicht und schnell lösbar, so dass sie einfach ausgewechselt werden können. Da es sich nicht vollständig vermeiden lässt, dass sich Beschichtungsmaterial, welches aus der Materialtasche 2 verdampft nicht nur auf dem Substrat, sondern auch auf anderen Teilen in der Vakuumkammer niederschlägt, baut sich auf dem Schutzelement 23 während des Arbeitsvorganges eine wenn auch geringe Beschichtung auf. Sobald diese ein störendes Ausmass erreicht, wird das Element 23 ausgewechselt und durch ein neues unbeschichtetes ersetzt. Infolge der gegenüber der Oberfläche 5 des Tiegels 1 und des zum Tiegel gehörenden Zwischenstückes 29 erhöht angeordneten Randbereiche 21 der Materialtaschen 2, 3 wird verhindert, dass aus der Materialtasche 2 austretende Materialteilchen direkt auf die Abdichtung 8 auftreffen und auf dieser eine Beschichtung aufbauen können. Zusätzlich wird dieser Schutz durch die überstehende Kante des Schutzelementes 23 gewährleistet. Die erfindungsgemässe Vorrichtung ermöglicht somit ein sicheres Abdecken der nicht am Beschichtungsprozess beteiligten Materialtaschen, im dargestellten Beispiel die Materialtasche 3, und gewährleistet gleichzeitig das störungsfreie Verschwenken dieser Materialtasche 3 in die Arbeitsposition und, parallel dazu, das Verschwenken der Materialtasche 2 in die Reserveposition. Besonders wirksam wird diese Lösung, wenn mehr als zwei Materialtaschen am Tiegel 1 vorhanden sind und Substrate mit komplexen Schichtaufbauten hergestellt werden. Die erfindungsgemässe Einrichtung gewährleistet dabei eine störungsfreie Arbeitsweise über den ganzen Prozessablauf und verhindert, dass das Material in irgend einer der auf dem Tiegel 1 angeordneten Materialtaschen durch verdampfendes Material einer anderen Tasche verunreinigt wird. Dadurch wird die Qualität der erzeugten Beschichtungen erhöht und gleichzeitig die Ausschussquote wesentlich reduziert. Dies ist insbesondere darauf zurückzuführen, dass während der Bearbeitung einer Charge die Dreh- und Verschwenkbewegungen des Tiegels 1 ungestört ausgeführt werden können, ohne dass die Funktionsweise der Abdeckung 4 beeinträchtigt würde. Ein Fluten der Vakuumkammer während des Bearbeitungsablaufes infolge von Störungen zwischen Abdeckung 4 und Tiegel 1 wird somit vollständig vermieden. Die kritischen Bauteile wie Schutzelement 23 und Zwischenstück 29 können, wenn nötig, während den Wartungsarbeiten, bzw. -Unterbrüchen leicht und einfach ausgewechselt und dadurch optimale mechanische Bedingungen geschaffen werden.

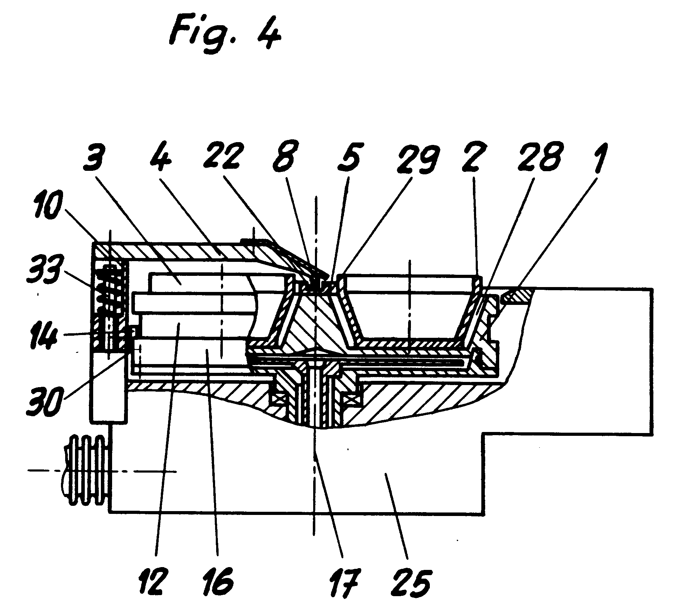

Figur 4 zeigt eine Ausführungsform, bei welcher die Abdeckung 4 nicht schwenkbar, sondern parallel zur Zentralachse 17 verschiebbar ist. Dazu sind an der hinteren Schürze 10 sowie an den nicht dargestellten seitlichen Schürzen 9, 11 Führungen 33 angeordnet, welche ein zur Zentralachse 17 paralleles Bewegen der Abdeckung 4 ermöglichen. Um diese Bewegung einwandfrei sicherzustellen, sind mindestens drei Führungen 33 notwendig, welche im dargestellten Beispiel um je 90° versetzt sind. Es sind auch drei Führungselemente 14 vorhanden, welche in der Führungsbahn 12 mit vier um 90° versetzten Vertiefungen 30 zusammenwirken. Diese Anordnung ist für Tiegel 1 mit vier Vertiefungen 28, bzw. Materialtaschen 2, 3 geeignet.

Enthält der Tiegel 1 nur zwei Vertiefungen 28 für die Materialtaschen 2 und 3. so weist die Führungsbahn 12 zwei Vertiefungen 30 auf, welche auch hier wiederum um 180° versetzt sind. Die Uebertragung der Verschiebungsbewegung der Abdeckung 4 von dem Führungselement 14 an der hinteren Schürze 10 auf die Führungselemente an den Seitenschürzen 9 und 11 erfolgt durch nicht dargestellte mechanische Hilfseinrichtungen oder dadurch, dass am Mantel 16 des Tiegels 1 zwei Führungsbahnen 12 angeordnet sind, wovon eine der Führung des Führungselementes 14 an der hinteren Schürze 10, und die zweite der Führung der Führungselemente an den Seitenschürzen 9 und 11 dient. Diese beiden Führungsbahnen 12 weisen dann je zwei Vertiefungen 30 auf, welche entsprechend den Führungselementen positioniert sind. Wird der Tiegel 1 um die Zentralachse 17 verdreht, so wird das Führungselement 14 aus der Vertiefung 30 ausgelenkt und bewirkt ein Verschieben der hinteren Schürze 10 nach oben. Diese Bewegung erfolgt infolge der Führung 33 parallel zur Zentralachse 17, wodurch die Abdichtung 8 von der Oberfläche 5 des Zwischenstückes 29 abgehoben wird. Die Nute 22 ist auch hier gleich ausgebildet, wie dies in Figur 3 dargestellt und beschrieben ist. Anhand der Figur 4 ist auch leicht ersichtlich, dass der Tiegel 1 so ausgebildet werden kann, dass dieser in Richtung der Zentralachse 17 abgesenkt werden könnte und dann die Abdeckung 4 feststehen würde. Bei geeigneter Konstruktion der Antriebselemente im Trägerblock 25 lässt sich diese Lösung in einfacher Weise aus der in Figur 4 dargestellten Lösung ableiten.

## Patentansprüche

1. Tiegelabdeckung für Beschichtungsanlagen mit einer Elektronenstrahlquelle als Energiequelle, mit einem schwenk- oder drehbaren Tiegel mit mehreren Materialtaschen und einer Abdeckung für die nicht mittels der Energiequelle beheizten Materialtaschen, dadurch gekennzeichnet, dass zwischen der Abdeckung (4) und dem Tiegel (1) eine Hubeinrichtung (7) angeordnet ist, der Abstand zwischen der Abdeckung (4) und der Oberfläche (5) des Tiegels (1) mittels dieser Hubeinrichtung (7) verstellbar ist, am Rande (6) der Abdeckung (4) zwischen dieser und dem Tiegel (1) Abdichtungen (8) angeordnet sind und diese Abdichtungen (8) mindestens teilweise mit der Oberfläche (5) des Tiegels (1) zusammenwirken.

2. Tiegelabdeckung nach Patentanspruch 1, dadurch gekennzeichnet, dass die Abdeckung seitliche Schürzen (9, 10, 11) aufweist und die nicht von der Energiequelle beaufschlagten Materialtaschen (3) und den zugehörigen Teil des Tiegels (1) haubenartig abschirmt.

3. Tiegelabdeckung nach einem der Patentansprüche 1 oder 2, dadurch gekennzeichnet, dass die Hubeinrichtung (7) aus einem ersten Einrichtungsteil bestehend aus einer Führungsbahn (12) und einem zweiten Einrichtungsteil bestehend aus Führungselementen (13, 14, 15), welche zwangsweise in der Führungsbahn (12) geführt sind, gebildet ist, und eines dieser Einrichtungsteile mit dem Tiegel (1) und das andere Einrichtungsteil mit der Abdeckung (4) verbunden ist.

4. Tiegelabdeckung nach Patentanspruch 3, dadurch gekennzeichnet, dass die Führungsbahn (12) so gestaltet ist, dass die Führungselemente (13, 14, 15) während Positionsänderungen des Tiegels (1) in einer Position geführt werden, in welcher zwischen Abdeckung (4) und Tiegeloberfläche (5) ein freier Durchlass (24) eingestellt ist.

5. Tiegelabdeckung nach Patentanspruch 3, dadurch gekennzeichnet, dass die Führungsbahn (12) am Mantel (16) des Tiegels (1) angeordnet und mit diesem um die Zentralachse (17) des Tiegels (1) drehbar ist, und die Führungselemente (13, 14, 15) mit der Abdeckung (4) verbunden und etwa parallel zur Zentralachse (17) des Tiegels (1) verschiebbar sind.

6. Tiegelabdeckung nach einem der Patentansprüche 1 bis 5, dadurch gekennzeichnet, dass die Abdeckung (4) um eine etwa rechtwinklig zur Zentralachse (17) des Tiegels (1) verlaufende Achse (18) schwenkbar ist und diese Achse (18) an dem von der Zentralachse (17) entfernten Teil (20) der Abdeckung (4) angeordnet ist.

7. Tiegelabdeckung nach einem der Patentansprüche 1 bis 5, dadurch gekennzeichnet, dass an der Abdeckung (4) etwa parallel zur Zentralachse (17) des Tiegels (1) verlaufende Führungen (33) angeordnet sind und die ganze Abdeckung (4) etwa parallel zur Richtung der Zentralachse (17) von der Oberfläche (5) des Tiegels (1) abhebbar ist.

8. Tiegelabdeckung nach einem der Patentansprüche 1 bis 7, dadurch gekennzeichnet, dass die Oberkante (21) der Materialtaschen (2, 3) mindestens einen Millimeter über die mit den Abdichtungen (8) der Abdeckung (4) zusammenwirkende Oberfläche (5) des Tiegels (1) vorsteht.

9. Tiegelabdeckung nach einem der Patentansprüche 1 bis 8, dadurch gekennzeichnet, dass an der Oberfläche (5) des Tiegels (1) eine durch das Zentrum verlaufende Nute (22) angeordnet ist, die Breite dieser Nute (22) vom Zentrum ausgehend nach aussen divergiert, und die vordere Dichtung (8) der Abdeckung (4) in diese Nute eingreift.

10. Tiegelabdeckung nach einem der Patentansprüche 1 bis 9, dadurch gekennzeichnet, dass an der Frontfläche der Abdeckung (4) ein auswechselbares Schutzelement (23) angeordnet ist.

## Claims

1. A crucible cover for coating apparatus with an electron beam source as energy source, with a pivotable or rotatable crucible comprising a plurality of material pockets and a cover for the material pockets not heated by means of the energy source, characterised in that a lifting device (7) is arranged between the cover (4) and the crucible (1), the distance between the cover (4) and the surface (5) of the crucible (1) is adjustable by means of this lifting device (7), seals (8) are arranged at the edge (6) of the cover (4) between the cover and the crucible (1), and these seals (8) cooperate at least partially with the surface (5) of the crucible (1).

2. A crucible cover as claimed in Claim 1, characterised in that the cover comprises lateral skirts (9, 10, 11) and screens the material pockets (3), which are not acted upon by the energy source, and the associated part of the crucible (1) in the manner of a hood.

3. A crucible cover as claimed in one of Claims 1 or 2, characterised in that the lifting device (7) is formed by a first device component, consisting of a guide path (12), and by a second device component consisting of guide elements (13, 14, 15) which are forcibly guided in the guide path (12), and one of these device components is connected to the crucible (1) and the other device component is connected to the cover (4).

4. A crucible cover as claimed in Claim 3, characterised in that the guide path (12) is designed such that during changes of position of the crucible (1), the guide elements (13, 14, 15) are guided in a position in which a free passage (24) is set between the cover (4) and the crucible surface (5).

5. A crucible cover as claimed in Claim 3, characterised in that the guide path (12) is arranged on the outer casing (16) of the crucible (1) and is rotatable together with the latter about the central axis (17) of the crucible (1), and the guide elements (13, 14, 15) are connected to the cover (4) and are displaceable approximately in parallel to the central axis (17) of the crucible (1).

6. A crucible cover as claimed in one of Claims 1 to 5, characterised in that the cover (4) is pivotable about an axis (18) extending approximately at right angles to the central axis (17) of the crucible (1), and this axis (18) is arranged on that part (20) of the cover (4) remote from the central axis (17).

7. A crucible cover as claimed in one of Claims 1 to 5, characterised in that guides (33), extending approximately in parallel to the central axis (17) of the crucible (1), are arranged on the cover (4), and the entire cover (4) can be lifted from the surface (5) of the crucible (1) approximately in parallel to the direction of the central axis (17).

8. A crucible cover as claimed in one of Claims 1 to 7, characterised in that the upper edge (21) of the material pockets (2, 3) projects by at least one millimetre beyond the surface (5) of the crucible (1) which cooperates with the seals (8) of the cover (4).

9. A crucible cover as claimed in one of Claims 1 to 8, characterised in that a groove (22) is arranged in the surface (5) of the crucible (1) extending through the centre, the breadth of this groove (22) diverges outwards from the centre, and the front seal (8) of the cover (4) engages into this groove.

10. A crucible cover as claimed in one of Claims 1 to 9, characterised in that an exchangeable protective element (23) is arranged on the front surface of the cover (4).

## Revendications

1. Couvercle de creuset pour installations de revêtement dont la source d'énergie est une source de faisceau électronique, comportant un creuset capable de pivoter ou de tourner avec plusieurs poches de matériau et un couvercle pour les poches de matériau qui ne sont pas chauffées au moyen de la source d'énergie, caractérisé en ce qu'un dispositif de levage (7) est disposé entre le couvercle (4) et le creuset (1), la distance entre le couvercle (4) et la surface (5) du creuset (1) est modifiable au moyen de ce dispositif de levage (7), des joints d'étanchéité (8) sont disposés au bord (6) du couvercle (4), entre celui-ci et le creuset (1), et ces joints d'étanchéité (8) coopèrent au moins en partie avec la surface (5) du creuset (1).

2. Couvercle de creuset selon la revendication 1, caractérisé en ce que le couvercle comporte des tabliers latéraux (9, 10, 11) et protège à la manière d'un capot les poches de matériau (3) qui ne sont pas sollicitées par la source d'énergie et la partie correspondante du creuset (1).

3. Couvercle de creuset selon l'une des revendications 1 et 2, caractérisé en ce que le dispositif de levage (7) est formé par une première partie de dispositif consistant en une voie de guidage (12) et en une seconde partie de dispositif consistant en éléments de guidage (13, 14, 15) qui sont guidés de manière forcée dans la voie de guidage (12), l'une de ces parties de dispositif étant reliée au creuset (1) et l'autre partie de dispositif étant reliée au couvercle (4).

4. Couvercle de creuset selon la revendication 3, caractérisé en ce que la voie de guidage (12) est agencée de telle manière que les éléments de guidage (13, 14, 15) sont amenés, pendant les modifications de position du creuset (1), dans une position dans laquelle il se forme un passage libre (24) entre le couvercle (4) et la surface (5) du creuset.

5. Couvercle de creuset selon la revendication 3, caractérisé en ce que la voie de guidage (12) est agencée au niveau de l'enveloppe (16) du creuset (1) et est capable de tourner avec celui-ci autour de l'axe central (17) du creuset (1), et les éléments de guidage (13, 14, 15) sont reliés au couvercle (4) et sont déplaçables sensiblement parallèlement à l'axe central (17) du creuset (1).

6. Couvercle de creuset selon l'une des revendications 1 à 5, caractérisé en ce que le couvercle (4) est capable de pivoter autour d'un axe (18) qui s'étend sensiblement perpendiculairement à l'axe central (17) du creuset (1), et cet axe (18) est agencé au niveau de la partie (20) du couvercle (4) qui est distante de l'axe central (17).

7. Couvercle de creuset selon l'une des revendications 1 à 5, caractérisé en ce que des guides (33) qui s'étendent sensiblement parallèlement à l'axe central (17) du creuset (1) sont disposés sur le couvercle (4) et l'ensemble du couvercle (4) est capable d'être relevé de la surface (5) du creuset (1) sensiblement parallèlement à la direction de l'axe central (17).

8. Couvercle de creuset selon l'une des revendications 1 à 7, caractérisé en ce que le bord supérieur (21) des poches de matériau (2, 3) dépasse d'au moins 1 mm au-dessus de la surface (5) du creuset (1) qui coopère avec les joints d'étanchéité (8) du couvercle (4).

9. Couvercle de creuset selon l'une des revendications 1 à 8, caractérisé en ce qu'une rainure (22) qui passe par le centre est prévue sur la surface (5) du creuset (1), la largeur de cette rainure (22) augmentant vers l'extérieur à partir du centre et le joint d'étanchéité (8) antérieur du couvercle (4) pénétrant dans cette rainure.

10. Couvercle de creuset selon l'une des revendications 1 à 9, caractérisé en ce qu'un élément de protection (23) interchangeable est disposé sur la surface frontale du couvercle (4).
